# EUROPEAN PATENT APPLICATION

(11) **EP 4 369 534 A1**
(43) Date of publication of application: **15.05.2024**
(21) Application number: 22868928.7
(22) Date of filing: 16.08.2022
(51) Int. Cl.: H01R 43/18, H01R 13/6591, H01R 13/648, H01R 13/40, H01R 13/46

(54) **CONNECTOR, MANUFACTURING METHOD, INTERCONNECTION SYSTEM, AND COMMUNICATION DEVICE**

(30) Priority: 15.09.2021 CN 202111081149
(71) Applicant: Huawei Technologies Co., Ltd., Longgang Shenzhen, Guangdong 518129 (CN)
(72) Inventor: CAO, Shuzhao, Shenzhen, Guangdong 518129 (CN); QIU, Shuang, Shenzhen, Guangdong 518129 (CN); YANG, Xichen, Shenzhen, Guangdong 518129 (CN); ZHANG, Jie, Shenzhen, Guangdong 518129 (CN)
(74) Representative: Huawei European IPR
(86) International application number: PCT/CN2022/112821
(87) International publication number: WO 2023/040552

(57) **Abstract**

This application provides a connector, a connector preparation method, an interconnection system, and a communication device, to achieve comparatively low costs, comparatively good electrical performance, and connector fabrication process simplification. The connector may include a base structure. At least one first via hole is disposed between a first surface and second surface of the base structure. The first surface has a first metal layer and a first clearance region that is in one-to-one correspondence with the at least one first via hole. The first clearance region is of a ring-shaped structure. The first via hole is located in a region encircled by the corresponding first clearance region. The first clearance region does not overlap the first metal layer. The second surface has a second metal layer and a second clearance region that is in one-to-one correspondence with the at least one first via hole. The second clearance region is of a ring-shaped structure. The first via hole is located in a region encircled by the corresponding second clearance region. The second clearance region does not overlap the second metal layer. A surface, of the base structure, other than the first surface and the second surface has a third metal layer.

## Description

### CROSS-REFERENCE TO RELATED APPLICATIONS

This application claims priority to Chinese Patent Application No. 202111081149.3, filed with the China National Intellectual Property Administration on September 15, 2021 and entitled "CONNECTOR, CONNECTOR PREPARATION METHOD, INTERCONNECTION SYSTEM, AND COMMUNICATION DEVICE", which is incorporated herein by reference in its entirety.

### TECHNICAL FIELD

This application relates to the field of communication technologies, and in particular, to a connector, a connector preparation method, an interconnection system, and a communication device.

### BACKGROUND

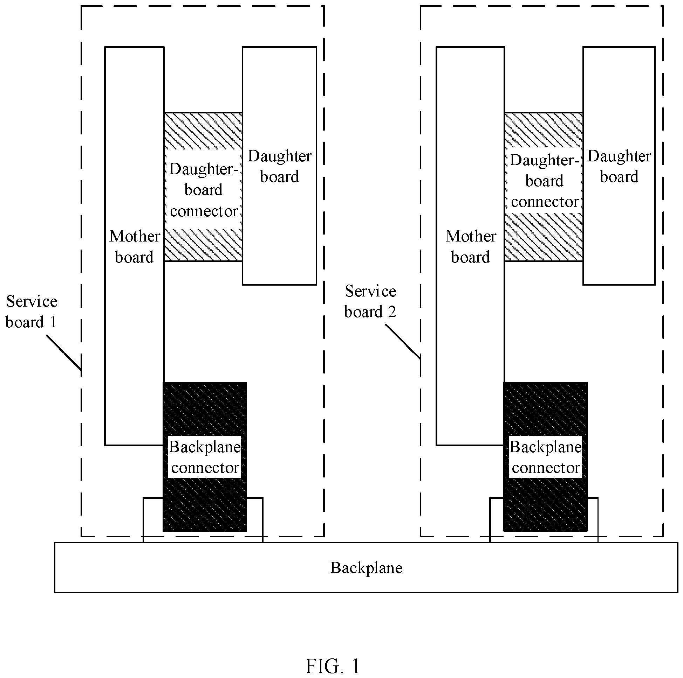

Currently, in a communication device, a high-speed link usually includes a backplane and a service board. As shown in FIG. 1, the backplane and the service board are connected to each other by using a backplane connector. The service board includes a daughter board and a mother board that are connected by using a daughter-board connector. The backplane connector (that is, a connector configured to connect the backplane and the service board) and the daughter-board connector (that is, a connector configured to connect the daughter board and the mother board) are also key components used for network interconnection (communication device interconnection) in a communication device system.

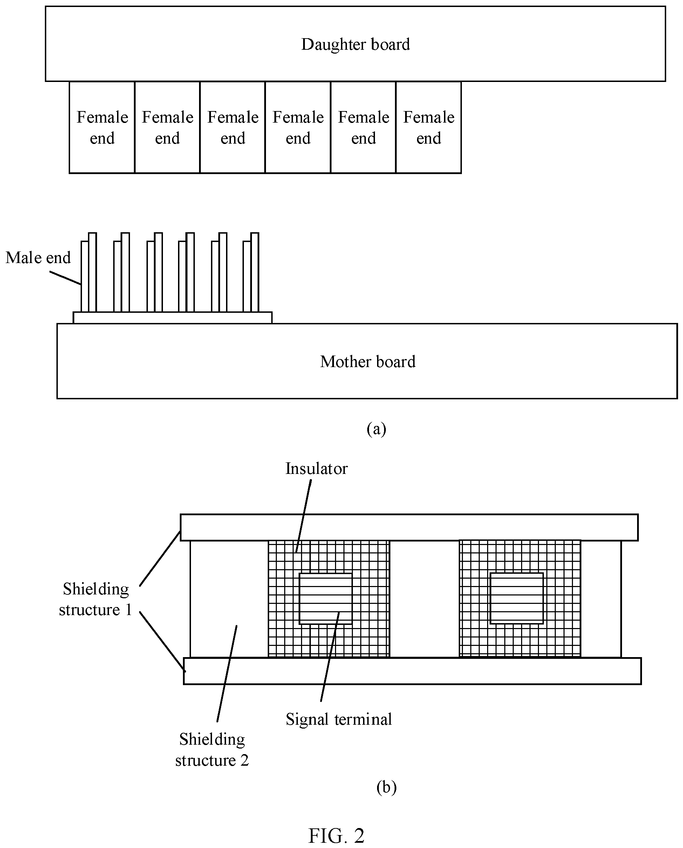

A common daughter-board connector is of a two-piece type, and includes two parts: a male end and a female end. As shown in (a) in FIG. 2, the male end and the female end are respectively fastened to a mother board and a daughter board through crimping or welding. The mother board and the daughter board are interconnected through fitting between the male end and the female end. Each of the male end and the female end includes three types of elements: a signal terminal, a metal shielding structure, and an insulator, as shown in a schematic sectional view in (b) in FIG. 2. To achieve comparatively good shielding performance, usually, a plurality of forms of shielding structures are designed. There needs to be reliable contact between shielding structures in different forms. It can be learned that a two-piece daughter-board connector not only has a large quantity of parts and a complex fabrication process, but also increases connector costs.

### SUMMARY

This application provides a connector, a connector preparation method, an interconnection system, and a communication device, to achieve comparatively low costs, comparatively good electrical performance, and connector fabrication process simplification.

According to a first aspect, this application provides a connector, which may be applied to connecting a plurality of to-be-connected objects. For example, the to-be-connected object may be a printed circuit board or a component. For example, a plurality of printed circuit boards are connected, or two components are connected, or a component and a printed circuit board are connected. The connector includes a base structure. A material of the base structure is an insulating material. At least one first via hole is disposed between a first surface and second surface of the base structure. The first via hole may also be referred to as a signal via hole or a signal hole. The first via hole may accommodate a conductor. The conductor may be configured to connect the to-be-connected objects. Metal layers are disposed on the first surface and second surface of the base structure. The second surface is located on a side, of the base structure, facing away from the first surface. The first surface has a first metal layer and a first clearance region that is in one-to-one correspondence with the at least one first via hole. The first clearance region is of a ring-shaped structure. The first via hole is located in a region encircled by the corresponding first clearance region. The first clearance region does not overlap the first metal layer. The second surface has a second metal layer and a second clearance region that is in one-to-one correspondence with the at least one first via hole. The second clearance region is of a ring-shaped structure. The first via hole is located in a region encircled by the corresponding second clearance region. The second clearance region does not overlap the second metal layer. A surface, of the base structure, other than the first surface and the second surface has a third metal layer. According to such a design, the first clearance region and second clearance region corresponding to the first via hole can isolate the first via hole from other metal structures, so that the first metal layer on the first surface, the second metal layer on the second surface, and the third metal layer on the another surface of the base structure jointly form a shielding structure. In this embodiment of this application, the first via hole may accommodate conduction such as a signal terminal or a metal layer for connecting two to-be-connected objects, so as to form a signal transmission path. It can be learned that the connector provided in this application may be a one-piece connector, and does not need an element such as a spring arm or a solder ball. The connector provided in this application can not only connect two to-be-connected objects but also improve signal transmission quality between the two to-be-connected objects. In addition, the connector has a simple structure, a comparatively small quantity of parts, comparatively high assembly efficiency, and a comparatively simplified fabrication process. In some possible scenarios, the base structure may be made of a plastic material. A molten plastic is injected into a product mold by using pressure, and cools and hardens into shape, thereby obtaining the base structure.

In a possible design, an inner wall of the first via hole is provided with a metal layer. The region encircled by the first clearance region is greater than a diameter of the corresponding first via hole, and a pad is formed between an inner edge of the first clearance region and the inner wall of the corresponding first via hole; and/or the region encircled by the second clearance region is greater than the diameter of the corresponding first via hole, and a pad is formed between an inner edge of the second clearance region and the inner wall of the corresponding first via hole. The pad on the first surface or the second surface may be connected to the to-be-connected object through welding or the like, so that a to-be-connected object 1 and a to-be-connected object 2 can be interconnected, and a signal can be transmitted through a signal transmission channel formed based on the pad and the metal layer on the inner wall of the first via hole.

When the connector provided in this application is specifically configured, a projection, on the second surface, of the first clearance region corresponding to the first via hole may coincide with or not coincide with the second clearance region corresponding to the first via hole. In other words, a pattern of the first surface may be the same as or may be different from a pattern of the second surface. The first clearance region and the second clearance region can isolate the first via hole from a metal structure of the connector, and consistency between the pattern of the first surface and the pattern of the second surface may not be required, so that a fabrication process can be simplified.

In a possible design, the conductor accommodated in the first via hole is a signal terminal. The connector may further include the signal terminal. The signal terminal may be adapted to the first via hole. One end of the signal terminal may be connected to the to-be-connected object 1, and the other end of the signal terminal may be connected to the to-be-connected object 2.

To improve an effect of isolation between first via holes and reduce near-end crosstalk and far-end crosstalk, at least one grounding via hole may be disposed between the first surface and the second surface, and an inner wall of the grounding via hole may be provided with a metal layer.

In some scenarios, the connected to-be-connected object is usually provided with a guiding hole, which has a function of positioning the connector and may also facilitate indicating a connection region of the connector. In a possible design, the connector may further include at least one guiding post located on the first surface and at least one guiding post located on the second surface. The to-be-connected object is provided with a guiding hole configured to fit the guiding post. The guiding hole disposed on the to-be-connected object can accommodate the guiding post on the connector, thereby facilitating fastening of the connector or mounting and position limiting of the connector.

To improve a convenience degree of connecting the to-be-connected objects by the connector, the connector further includes at least one solder support post located on the first surface and at least one solder support located on the second surface. A thickness of the solder support post is less than a thickness of the guiding post. When the guiding post is fitted into the guiding hole, the solder support posts support the to-be-connected objects, so that gaps are formed between the first surface and the to-be-connected object and between the second surface and the to-be-connected object. The gaps are used for welding. The gap may be configured to accommodate a welding joint for welding, and the gap may also indicate a thickness of the welding joint for welding, to avoid an overflow caused by an excessively large welding joint volume.

In a possible design, the base structure may be provided with at least one cavity. The cavity may accommodate a component on the to-be-connected object or accommodate another component. In some scenarios, an inner wall of the cavity may be entirely or partly provided with a metal layer.

According to a second aspect, this application provides a preparation method of the connector according to any one of the first aspect or the designs thereof. The method may include: forming a base structure in the connector, where a material of the base structure is an insulating material, at least one first via hole is disposed between a first surface and second surface of the base structure, the first via hole is configured to accommodate a conductor, the conductor is configured to connect two to-be-connected objects, and the second surface is located on a side, of the base structure, facing away from the first surface; forming metal layers on all surfaces of the base structure; and based on an image composition process, forming a first pattern on the first surface and forming a second pattern on the second surface, where the first pattern includes a first clearance region that is in one-to-one correspondence with the at least one first via hole, the first clearance region is of a ring-shaped structure, the first via hole is located in a region encircled by the corresponding first clearance region, the second pattern includes a second clearance region that is in one-to-one correspondence with the at least one first via hole, the second clearance region is of a ring-shaped structure, and the second via hole is located in a region encircled by the corresponding second clearance region.

In a possible design, the insulating material is plastic. The forming a base structure in the connector may be: forming the base structure through an injection molding process.

In a possible design, the forming metal layers on all surfaces of the base structure may be: forming the metal layers on all the surfaces of the base structure through an electroplating process or a chemical plating process.

In a possible design, the based on an image composition process, forming a first pattern on the first surface and forming a second pattern on the second surface may be: performing laser engraving processing or etching processing on the first surface to form the first pattern on the first surface; and performing laser engraving processing or etching processing on the second surface to form the second pattern on the second surface.

According to a third aspect, this application provides a communication apparatus. The communication apparatus includes the connector according to any one of the first aspect or the designs of the first aspect.

According to a fourth aspect, this application provides a communication apparatus. The communication apparatus includes a connector prepared by using the preparation method according to any one of the second aspect or the designs of the second aspect.

According to a fifth aspect, this application provides an interconnection system. The system may include the connector according to any one of the first aspect or the designs of the first aspect and to-be-connected objects. The connector may be configured to connect the to-be-connected objects, so as to facilitate signal transmission between the to-be-connected objects.

According to a sixth aspect, this application provides a communication device, which may include one or more interconnection systems, where at least one interconnection system may include the connector according to any one of the first aspect or the designs of the first aspect. Usually, the connector and to-be-connected objects may constitute the interconnection system or an interconnection architecture. For interconnection systems with different types of connectors, it may be considered that the interconnection systems are also of different types. In some examples, each of connectors in all the interconnection systems included in the communication device may be the connector according to any one of the first aspect or the designs of the first aspect. In some other examples, a connector in some of the interconnection systems in the communication device may be the connector according to any one of the first aspect or the designs of the first aspect, and a connector in the rest of the interconnection systems may be another type of connector.

For technical effects that can be achieved by any one of the second aspect to the sixth aspect or the possible designs thereof, refer to the technical effects that can be achieved by any one of the first aspect or the possible designs of the first aspect. Details are not described herein again.

### BRIEF DESCRIPTION OF DRAWINGS

FIG. 1 is a schematic diagram of a connection relationship between a mother board and a daughter board;
FIG. 2 is a schematic diagram of a structure of a two-piece connector;
FIG. 3 is a schematic diagram of a structure of a one-piece connector;
FIG. 4 is a schematic diagram of a structure of a connector according to an embodiment of this application;
FIG. 5 is a sectional view at an A-A direction in FIG. 4;
FIG. 6 is a schematic diagram of a first surface or second surface of a connector;
FIG. 7 is a schematic diagram of a pad on a connector;
FIG. 8 is a schematic diagram of a grounding via hole on a connector;
FIG. 9 is a schematic diagram of a guiding post on a connector;
FIG. 10 is a schematic diagram of a guiding post on a connector;
FIG. 11 is a schematic diagram of a solder support post on a connector;
FIG. 12 is a schematic diagram of a structure of a connector according to an example embodiment;
FIG. 13 is a top view of a connector according to an example embodiment;
FIG. 14 is a schematic diagram of a structure of a connector including a signal terminal according to an example embodiment;
FIG. 15 is a top view of a connector according to an example embodiment;
FIG. 16 is a schematic flowchart of a connector preparation method;
FIG. 17 is a schematic diagram of a connector preparation process; and
FIG. 18 is a schematic diagram of a crosstalk status of a connector.

### DESCRIPTION OF EMBODIMENTS

To make the objectives, technical solutions, and advantages of this application clearer, the following further describes this application in detail with reference to the accompanying drawings. For ease of understanding advantages of a connector provided in embodiments of this application, the following first describes an application scenario of the connector.

Currently, in a communication device system (which may also be referred to as a communication system), a high-speed link usually includes a backplane and a service board. Referring to FIG. 1, the backplane and the service board are connected to each other by using a backplane connector. The service board includes a daughter board and a mother board that are connected by using a daughter-board connector. The backplane connector (that is, a connector configured to connect the backplane and the service board) and the daughter-board connector (that is, a connector configured to connect the daughter board and the mother board) are also key components used for network interconnection (communication device interconnection) in the communication device system.

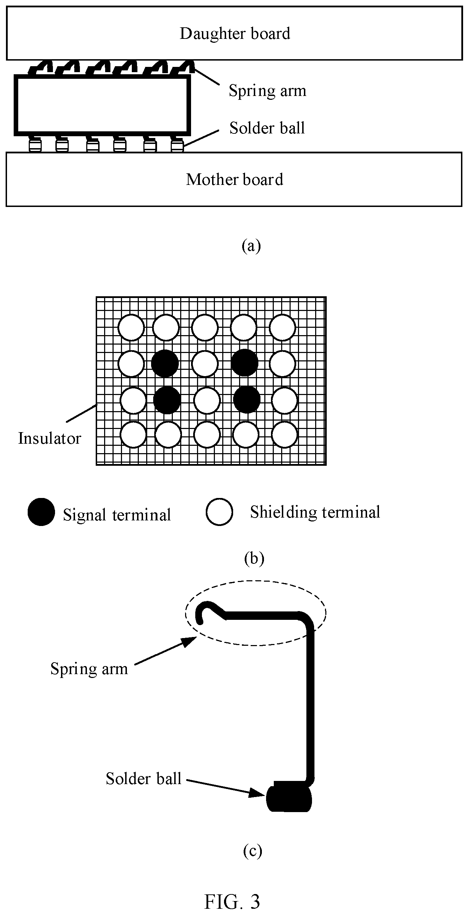

Common daughter-board connectors may be classified into two types. A first type is a two-piece connector. Referring to FIG. 2, The two-piece connector includes two parts: a male end and a female end. The male end and the female end are respectively fastened to a mother board and a daughter board through crimping or welding. The mother board and the daughter board are interconnected through fitting between the male end and the female end. Each of the male end and the female end includes three types of elements: a signal terminal, a metal shielding structure, and an insulator. A second type is a one-piece connector. Referring to (a) in FIG. 3, One side of the one-piece connector is connected to a mother board by using a solder ball, and the other side of the connector is provided with a spring arm, to interconnect a daughter board and the mother board through contact between a spring plate and a pattern on the daughter board. Referring to (b) in FIG. 3, The one-piece connector includes signal terminals and a shielding structure. The shielding structure includes shielding terminals. Crosstalk isolation between different signals is implemented through arrangement of the signal terminals and the shielding terminals. Referring to (c) in FIG. 3, One end of the signal terminal is designed with a solder ball through a ball placement process, and the other end of the signal terminal is designed as a spring arm. For the one-piece connector, processes such as stamping, injection molding, assembly, and ball placement are used. A fabrication process is complex, and costs are high. In addition, failure rates of ball placement and contact between the spring arm and the mother board and daughter board are comparatively high.

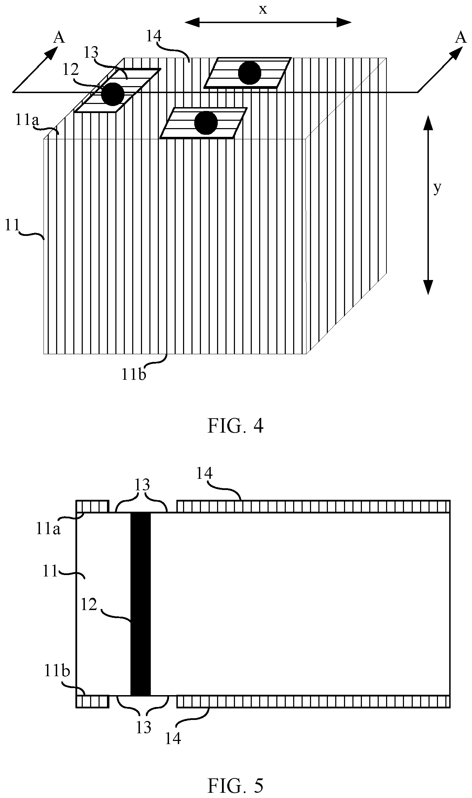

In a communication device system, electrical performance of a connector has comparatively large impact on signal transmission quality. The impact of the connector on signal transmission quality may be analyzed by using an eye diagram. All element waveforms obtained through scanning are overlapped by using an oscilloscope, to form the eye diagram. Referring to FIG. 4, An eye height, an eye width, and the like of the eye diagram are used. The eye height may reflect a noise margin of signal transmission of the connector. The eye width may reflect a stable time of signal transmission of the connector.

Evaluation of electrical performance of a connector usually includes key indicators such as crosstalk and an insertion loss. Crosstalk may be a coupling effect that generates harmful electrical signal interference in a process of transfer from one network to another network. Crosstalk may be classified into far-end crosstalk, near-end crosstalk, and the like. For a system signal, far-end crosstalk and near-end crosstalk of the connector cause noise. As a result, noise injection occurs in a communication network, and a signal-to-noise ratio of the signal is reduced, leading to negative impact on signal transmission quality. The connector may be provided with a terminal, that is, a metal structure configured to transmit a signal or provide a return path for a signal. The insertion loss may be a loss of energy in a process in which a signal is transmitted from one end of the terminal to the other end of the terminal.

A decrease in the insertion loss of the connector is represented by an increase in both an eye height and eye width in an eye diagram, that is, a noise margin of signal transmission of the connector and a stable time of signal transmission of the connector are both increased. The insertion loss of the connector is reduced mainly by using a signal terminal with higher electric conductivity or an insulating material with a lower loss angle. Interference from a signal to a surrounding signal can be reduced by reducing crosstalk of the connector. Crosstalk is reduced mainly by increasing a distance between two networks or adding more and tighter shielding conductors. Regardless of insertion loss reduction or crosstalk reduction, material costs and fabrication process costs of the connector are usually increased.

In view of this, this application provides a connector with comparatively low costs and comparatively good electrical performance, and a fabrication process of the connector is simplified.

Terms used in the following embodiments are merely intended to describe specific embodiments, but are not intended to limit this application. As used in the specification of this application and the appended claims, singular expression forms "one", "a", "the", "the foregoing", and "this" are intended to also include an expression form such as "one or more", unless otherwise specified in the context.

Referring to "an embodiment", "some embodiments", or the like described in this specification means that one or more embodiments of this application include a specific feature, structure, or characteristic described with reference to the embodiment. Therefore, statements such as "in an embodiment", "in some embodiments", "in some other embodiments", and "in some different embodiments" that appear at different places in this specification do not necessarily mean referring to a same embodiment, but mean "one or more but not all embodiments", unless otherwise specifically emphasized in another manner. The terms "include", "contain", "have", and variants thereof all mean "include but be not limited to", unless otherwise specifically emphasized in another manner. The following clearly and completely describes the technical solutions in embodiments of this application with reference to the accompanying drawings in embodiments of this application.

This application provides a connector. The connector can connect a plurality of to-be-connected objects. The to-be-connected object may be a printed circuit board (print circuit board, PCB), for example, a mother board or daughter board in a communication device. Alternatively, the to-be-connected object may be a component. The connector provided in this application may be configured to connect a plurality of PCBs, or may be configured to connect a plurality of components. Alternatively, the connector may be configured to connect a component and a PCB, for example, connect one or more components to a PCB. For ease of description, an example in which the connector connects PCBs is used for description below.

Referring to FIG. 4, A material of a base structure 11 is an insulating material, such as an inorganic insulating material, an organic insulating material, or a hybrid insulating material. In some examples, the base structure 11 may be made of a plastic material. Along a thickness direction of the base structure 11 (a direction y shown in FIG. 4), an upper surface and a lower surface of the base structure 11 may be respectively denoted as a first surface 11a and a second surface 11b. It can be learned that the second surface 11b is located on a side, of the base structure, facing away from the first surface.

At least one first via hole 12 is disposed between the first surface 11a and the second surface 11b. The first via hole may also be referred to as a signal hole or a signal via hole. The first via hole 12 penetrates the base structure 11. The second surface 11b is located on the side, of the base structure, facing away from the first surface. FIG. 5 is a sectional view at A-A in FIG. 4. Along the direction y, the first surface 11a has a metal layer 14 and a clearance region 13 that corresponds to the first via hole 12. The clearance region 13 does not overlap the metal layer 14 of the first surface 11a. In other words, there is no metal layer 14 in the clearance region 13. Similarly, the second surface also has a metal layer 14 and a clearance region 13 that corresponds to the first via hole 12, where the clearance region 13 does not overlap the metal layer 14 of the second surface 11b.

A metal layer 14 is disposed on each surface, of the base structure, other than the first surface and the second surface. The base structure may be a three-dimensional structure having a plurality of surfaces. For example, the base structure may be a cuboid, and the cuboid may have six surfaces. In the six surfaces, each of four surfaces other than the first surface and the second surface is provided with a metal layer 14. For another example, the base structure may be a cylinder, and the cylinder may have three surfaces. In the three surfaces, one surface other than the first surface and the second surface may be provided with a metal layer 14. For another example, the base structure may be a prism structure, such as a triangular prism, a quadrangular prism, or a pentagonal prism. A three-dimensional structure of the base structure may be set based on an actual scenario. This is not excessively limited in this application.

The metal layer 14 disposed on the first surface, the metal layer 14 disposed on the second surface, and the metal layer 14 disposed on the another surface of the base structure may form a shielding structure. In this embodiment of this application, the metal layer 14 may be one or more layers of metal, where a quantity of layers of metal is not specifically limited. A quantity of layers included in the metal layer 14 may be set based on a requirement, and details are not described herein. The metal layer 14 may include one or more types of metal. This is not excessively limited in this application.

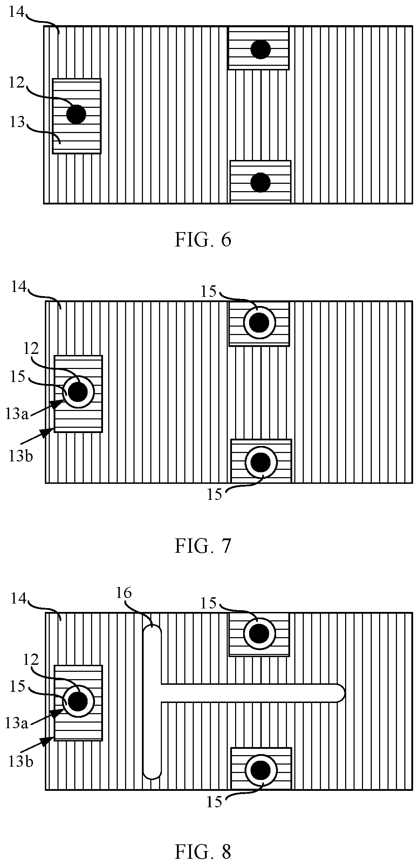

FIG. 6 shows the first surface 11a. The first surface 11a has the clearance region 13 that is in one-to-one correspondence with the at least one first via hole 12, and the clearance region 13 on the first surface 11a does not overlap the metal layer 14. Similarly, the second surface 11b has the clearance region 13 that is in one-to-one correspondence with the at least one first via hole 12, and the clearance region 13 on the second surface 11b does not overlap the metal layer 14. According to such a design, the metal layers 14 disposed on the first surface 11a and the second surface 11b can be respectively connected to two PCBs through welding.

For ease of distinguishment, in this application, the metal layer 14 disposed on the first surface 11a is denoted as a first metal layer, the clearance region on the first surface 11a is denoted as a first clearance region, the metal layer 14 disposed on the second surface 11b is denoted as a second metal layer, and the clearance region on the second surface 11b is denoted as a second clearance region. It should be understood that the first clearance region 13 does not overlap the first metal layer, and the second clearance region 13 does not overlap the second metal layer.

The clearance region on each of the first surface 11a and the second surface 11b may be of a ring-shaped structure. The first via hole 12 is located in a region encircled by the corresponding first clearance region 13, and the first via hole 12 is located in a region encircled by the corresponding second clearance region 13. In this application, shapes of outer contours and inner contours of ring-shaped structures of the clearance regions may be the same or may be different.

In some examples, for a same first via hole 12, a shape or size of a corresponding first clearance region on the first surface 11a may be the same as that of a corresponding second clearance region on the second surface 11b. In other words, a projection, along the direction y, of the first clearance region that corresponds to the first via hole 12 and that is on the first surface 11a is exactly the same as a projection, along the direction y, of the second clearance region that corresponds to the first via hole 12 and that is on the second surface 11b. Alternatively, for a same first via hole 12, a shape or size of a corresponding first clearance region on the first surface 11a may be different from that of a corresponding second clearance region on the second surface 11b. For example, any one or more of an outer contour shape, an outer contour size, an inner contour shape, an inner contour size, and the like of a projection, along the direction y, of the first clearance region that corresponds to the first via hole 12 and that is on the first surface 11a may be different from that of a projection, along the direction y, of the second clearance region that corresponds to the first via hole 12 and that is on the second surface 11b.

The first via hole 12 may accommodate a conductor. The conductor accommodated in the first via hole 12 may be configured to connect two PCBs. For example, one end of the conductor is connected to a PCB 1, and the other end of the conductor is connected to a PCB 2. In some examples, the conductor accommodated in the first via hole 12 may be a signal terminal. In some examples, an inner wall of the first via hole 12 is provided with a metal layer, so that the first via hole 12 can be used as a signal transmission channel. In some other examples, the connector provided in this application may include the conductor accommodated in the first via hole 12.

In this embodiment of this application, the first clearance region and second clearance region corresponding to the first via hole 12 isolate the first via hole from other metal structures, so that the base structure 11 and the metal layers 14 on the first surface 11a and the second surface 11b jointly form the shielding structure. The first via hole 12 may accommodate conduction such as a signal terminal or a metal layer for connecting two PCBs, so as to form a signal transmission path. It can be understood that the connector provided in this application may be a one-piece connector, and does not need an element such as a spring arm or a solder ball. The connector provided in this application can not only connect two PCBs but also improve signal transmission quality between the two PCBs. In addition, the connector has a simple structure, a comparatively small quantity of parts, comparatively high assembly efficiency, and a comparatively simplified fabrication process.

In a possible implementation, referring to FIG. 7, An inner wall of the first via hole 12 is provided with a metal layer. The region encircled by the clearance region 13 is greater than a diameter of the corresponding first via hole 12. FIG. 7 shows an inner contour or inner edge 13a of the clearance region 13 and an outer contour or outer edge 13b of the clearance region 13. In this embodiment of this application, a pad 15 is formed between the inner edge 13a of the clearance region 13 and the inner wall of the corresponding first via hole 12. The pad structure 15 is formed between the inner wall of the first via hole 12 and the inner edge 13a of the clearance region 13, to facilitate PCB welding and fastening, thereby implementing an electrical connection.

For example, on the first surface 11a, the region encircled by the first clearance region is greater than the diameter of the corresponding first via hole, and a pad is formed between an inner edge (inner contour) of the first clearance region and the inner wall of the corresponding first via hole. Similarly, the region encircled by the second clearance region is greater than the diameter of the corresponding first via hole, and a pad is formed between an inner edge (inner contour) of the second clearance region and the inner wall of the corresponding first via hole 12.

To improve an effect of isolation between first via holes, as shown in FIG. 8, the connector may be further provided with at least one grounding via hole 16. A shape enclosed by a contour of the grounding via hole 16 may be "T", "I", a circle, or the like. Alternatively, a shape enclosed by a contour of the grounding via hole 16 may be an irregular shape. This is not excessively limited in this application. An inner wall of the grounding via hole 16 is provided with a metal layer. Such a design can improve a shielding effect of signal transmission between first via holes 12, and reduce near-end crosstalk and far-end crosstalk.

In some application scenarios, the connected PCB is usually provided with a guiding hole, which has a function of positioning the connector and may also facilitate indicating a connection region of the connector. Referring to FIG. 8, The connector provided in embodiments of this application may further include at least one guiding post 21, which may be fitted into the guiding hole disposed on the PCB. The connector may include at least one guiding post 21 located on the first surface and at least one guiding post 21 located on the second surface. For example, the guiding hole disposed on the PCB can accommodate the guiding post 21 on the connector, thereby facilitating fastening of the connector or mounting and position limiting of the connector.

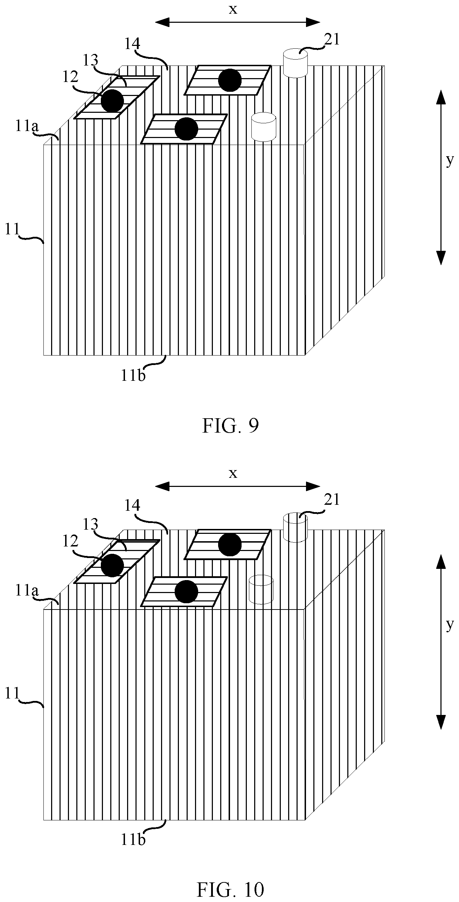

In a possible embodiment of this application, the guiding post 21 and the base structure 11 are made of a same material. Referring to FIG. 9 and FIG. 10 together, The guiding posts 21 and the base structure 11 are an integrally formed plastic structure, to simplify a processing process of the guiding posts 21 and the base 11, improve an integration degree of the connector, and thereby improve structure reliability of the connector. In another possible embodiment, the guiding post 21 and the base structure 11 are separated in structure. Materials of the guiding post 21 and the base structure 11 may be the same or may be different. Another possible structure may be further disposed between the guiding post 21 and the base structure 11, that is, the guiding post 21 and the base structure 11 are indirectly connected to each other.

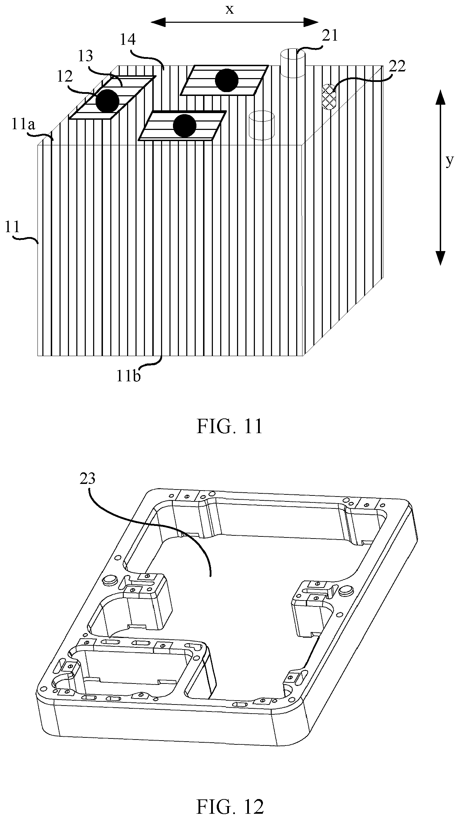

To improve a convenience degree of connecting the PCBs by the connector, referring to FIG. 11, The connector provided in embodiments of this application may further include at least one solder support post 22 located on the first surface 11a and at least one solder support post 22 located on the second surface 11b. A thickness of the solder support post 22 is less than a thickness of the guiding post. When the guiding post 21 is fitted into the guiding hole on the PCB, the solder support post 22 on the first surface 11a can support the PCB1, so that a gap is formed between the first surface 11a and the PCB 1. The gap may be configured to accommodate a welding joint for welding, and the gap may also indicate a thickness of the welding joint for welding, to avoid an overflow caused by an excessively large welding joint volume. Similarly, the solder support post 22 on the second surface 11b can support the PCB2, so that a gap is formed between the second surface 11b and the PCB2. The gap may also be configured to accommodate a welding joint for welding, and the gap may also indicate a thickness of the welding joint for welding, to avoid an overflow caused by an excessively large welding joint volume. Such a design can further improve assembly efficiency of the connector.

To reduce a weight of the connector and reduce costs, or adapt to a structure on the connected PCB, referring to FIG. 12, The connector provided in embodiments of this application may further include at least one cavity 23. FIG. 12 is a side view of the base structure 11 according to an example embodiment. The base structure 11 may include a plurality of cavities 23. Contour shapes and sizes of the cavities 23 may be the same or may be different. The cavity 23 may be configured to accommodate another component or a component on a to-be-connected object. Usually, a position, a contour shape, a size, and the like of the cavity 23 may be adapted based on a status of a position that needs to be connected on the connected PCB. This is not excessively limited in this application.

An inner wall of the cavity 23 is entirely or partly provided with a metal layer, to reduce crosstalk. In some examples, the inner wall of the cavity 23 is entirely provided with the metal layer. According to such a design, the metal layer on the inner wall of the cavity 23 can communicate with the metal layers on the first surface 11a and the second surface 11b. Alternatively, the inner wall of the cavity 23 is partly provided with the metal layer. For example, a part that is of the inner wall of the cavity 23 and that is closer to the first surface 11a and/or the second surface 11b has no metal layer, and a part that is of the inner wall of the cavity 23 and that is farther away from the first surface 11a and/or the second surface 11b is provided with the metal layer. Such a design can prevent the metal layer on the inner wall of the cavity 23 from communicating with the metal layer on the first surface 11a and/or the metal layer on the second surface 11b. This may be alternatively understood as that the inner wall of the cavity 23 may include the metal layer and at least one clearance region. The clearance region can prevent the metal layer of the first surface 11a or the second surface 11b from communicating with the metal layer of the inner wall of the cavity 23. In some scenarios, the clearance region on the inner wall of the cavity 23 may communicate with a part of the clearance region on the first surface 11a or the second surface 11b.

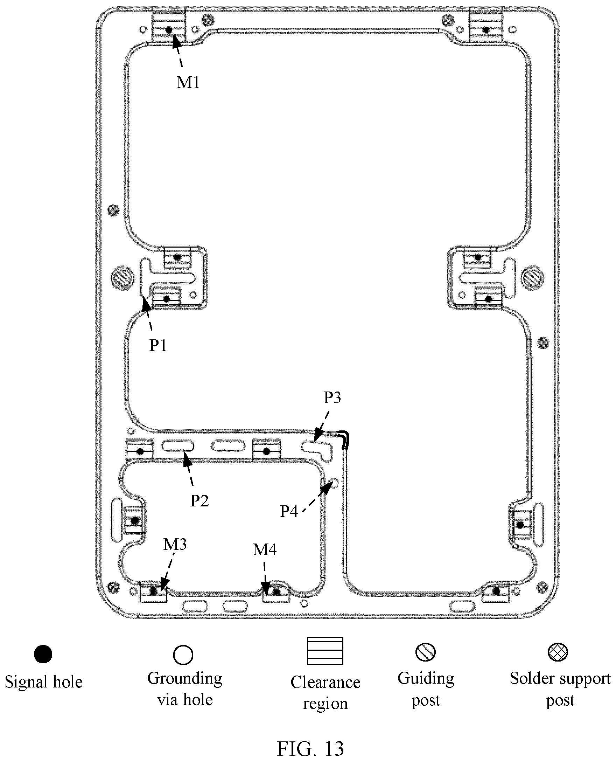

FIG. 13 is a top view of the first surface or second surface of the connector including the base structure 11 in FIG. 12. The first surface is used as an example for description. As shown in FIG. 13, the first surface 11a of the base structure 11 includes a plurality of clearance regions 13, a plurality of first via holes 12, a plurality of grounding via holes 16, a plurality of guiding posts 21, and a plurality of solder support posts 22. The first via hole 12 may accommodate a conductor, and the conductor is configured to connect PCBs to implement signal transmission. For example, the first via hole 12 may accommodate a signal terminal. The plurality of clearance regions 13 may include clearance regions of a plurality of shapes. For example, in FIG. 13, an outer contour shape of a clearance region at M1 may be a rectangle 1, and an outer contour shape of a clearance region at M2 may also be a rectangle 2, where a size of the rectangle 2 may be different from a size of the rectangle 1. An outer contour shape of a clearance region at M3 may be an irregular shape, and an outer contour shape of a clearance region at M4 may be an irregular shape. In this embodiment of this application, the clearance region is configured to isolate the first via hole 12 from the metal layer on the first surface 11a or the second surface 11b, thereby isolating the first via hole 12 from a metal structure. An inner contour shape and size and outer contour shape and size of the clearance region are not excessively limited.

Similarly, the plurality of grounding via holes 16 may include grounding via holes 16 of a plurality of shapes. The grounding via hole 16 may be referred to as a ground via hole. For example, in FIG. 13, a contour of a projection that is of a grounding via hole at P1 and that is on the first surface 11a or the second surface 11b may be in the shape of "T", and a contour of a projection that is of a grounding via hole at P2 and that is on the first surface 11a or the second surface 11b may be in the shape of "I". A contour of a projection that is of a grounding via hole at P3 and that is on the first surface 11a or the second surface 11b may be an irregular shape. A contour of a projection that is of a grounding via hole at P4 and that is on the first surface 11a or the second surface 1 1b may be a circle. In this embodiment of this application, an inner wall of the grounding via hole may be provided with a metal layer, thereby forming a shielding structure, which has a function of isolating signal interference. A contour shape and size of a projection of the grounding via hole on the first surface 11a or the second surface 11b are not excessively limited.

In some examples, the plurality of guiding posts 21 disposed on the base structure 11 may be symmetrically distributed on the base structure 11. Similarly, the solder support posts 22 may be symmetrically distributed on the base structure. Optionally, the guiding posts and/or the solder support posts are integrated with or separated from the base structure.

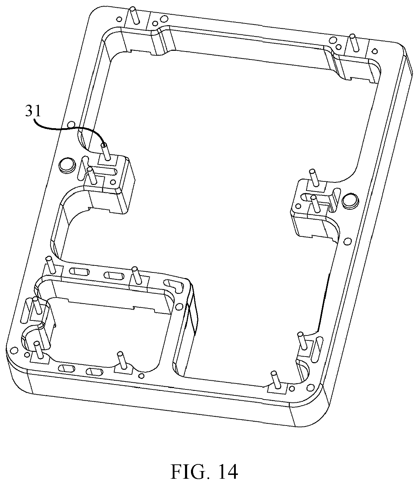

In a possible implementation, based on the foregoing structure, referring to FIG. 14, This application further provides a signal terminal 31, which may be fitted into (or adapted to) the first via hole 12 of the connector. The first via hole 12 may accommodate the signal terminal 31. Each first via hole 12 of the connector is provided with an adapted signal terminal 31. The signal terminal 31 may penetrate through the first via hole 12, where one end of the signal terminal 31 is connected to the PCB 1, and the other end of the signal terminal 31 may be connected to the PCB2, so that the PCB1 and the PCB2 are interconnected, and signal transmission can be performed.

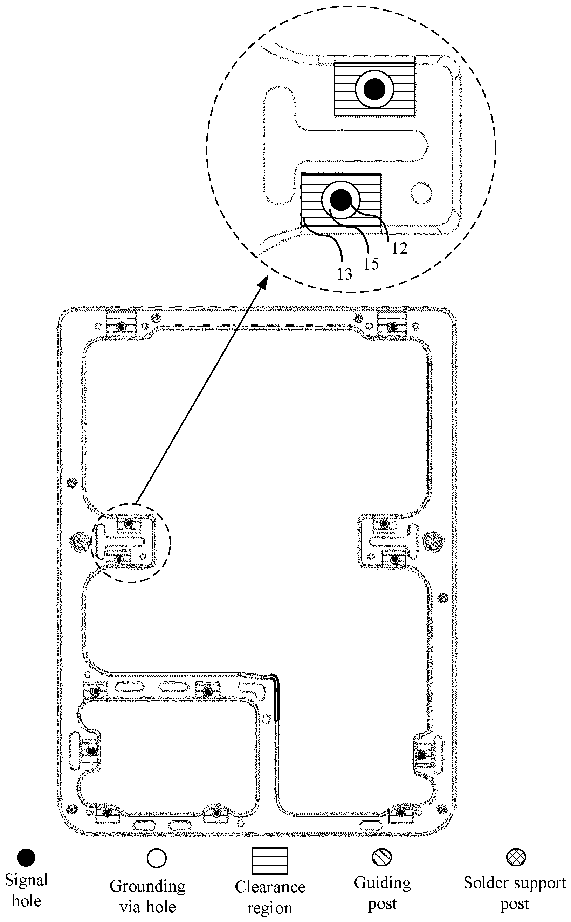

In another possible implementation, based on the base structure 11 in FIG. 12, an inner wall of each first via hole 12 is provided with a metal layer, and a pad is disposed between the first via hole 12 and a clearance region corresponding to the first via hole 12. FIG. 15 is a top view of the first surface or second surface of the connector including the pad according to an example embodiment. As shown in FIG. 13, the first surface 11a of the base structure 11 includes a plurality of clearance regions 13, a plurality of first via holes 12, a plurality of grounding via holes 16, a plurality of guiding posts 21, and a plurality of solder support posts 22. For the clearance region 13, the grounding via hole 16, the guiding post 21, and the solder support post 22, refer to the descriptions in the foregoing embodiment. Details are not described herein again.

In this example, the first via hole 12 may accommodate a conductor. For example, an inner wall of the first via hole 12 is provided with a metal layer. A region encircled by a clearance region corresponding to the first via hole 12 is greater than a diameter of the first via hole, and a pad 15 is formed between an inner edge or inner contour of the clearance region 13 and the inner wall of the first via hole 12. For any first via hole 12, a region encircled by the first clearance region 13 that corresponds to the first via hole 12 and that is on the first surface 11a is greater than a diameter of the first via hole 12, and a pad 15 is formed between an inner edge of the first clearance region 13 and an inner wall of the first via hole 12; and/or a region encircled by a second clearance region 13 that corresponds to the first via hole 12 and that is on the second surface 11b is greater than the diameter of the first via hole 12, and a pad 15 is formed between an inner edge of the second clearance region 13 and the inner wall of the corresponding first via hole 12. The pad 15 may be connected to the PCB through welding or the like, so that the PCB1 and the PCB2 can be interconnected, and a signal can be transmitted through a signal transmission channel formed based on the pad 15 and the metal layer on the inner wall of the first via hole 12.

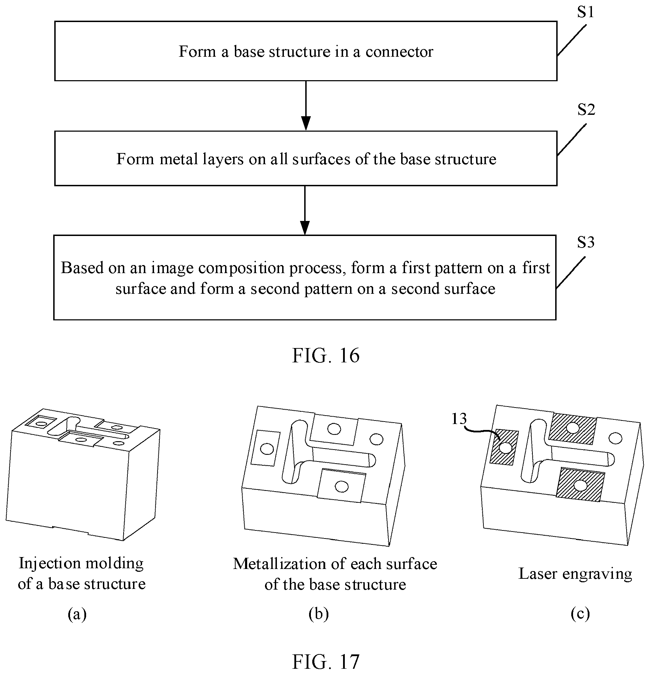

FIG. 16 is a schematic flowchart of a connector preparation method according to an embodiment of this application. The method is used to prepare a connector structure corresponding to FIG. 4, FIG. 12, and FIG. 15. Referring to the flowchart of the method shown in FIG. 16, the connector preparation method is as follows.

Step S1: Form a base structure in a connector.

In this embodiment of this application, an insulating material may be injected into a preset mold to form the base structure of the connector. In some examples, the base structure may be made of a plastic material. Referring to (a) in FIG. 17, The base structure of the connector is formed through plastic injection molding. At least one first via hole is disposed between a first surface and second surface of the formed base structure. The first via hole is configured to accommodate a conductor. The conductor is configured to connect the two printed circuit boards. The second surface is located on a side, of the base structure, facing away from the first surface.

In some examples, at least one grounding via hole may be further disposed between the first surface and second surface of the formed base structure; and/or a guiding post is disposed on each of the first surface and second surface of the formed base structure; and/or a solder support post is disposed on each of the first surface and second surface of the formed base structure.

Step S2: Form metal layers on all surfaces of the base structure.

In this embodiment of this application, referring to (b) in FIG. 17, A metal layer is formed on each surface of the base structure through an electroplating process or a chemical plating process.

The electroplating process usually means plating a surface of an element with a thin layer of metal or alloy by using an electrolytic principle. The chemical plating process (also referred to as an electroless plating process) usually refers to a plating method in which metal ions in a plating solution are reduced to metal by using a suitable reducing agent without applying a current, and the metal is deposited on a surface of an element.

Step S3: Based on an image composition process, form a first pattern on the first surface and form a second pattern on the second surface.

The first pattern may include a first clearance region that is in one-to-one correspondence with the at least one first via hole. The first clearance region is of a ring-shaped structure. The first via hole may be located in a region encircled by the corresponding first clearance region. The second pattern includes a second clearance region that is in one-to-one correspondence with the at least one first via hole. The second clearance region is of a ring-shaped structure. The second via hole is located in a region encircled by the corresponding second clearance region.

In some possible designs, a projection, on the second surface, of the first pattern formed on the first surface overlaps the second pattern formed on the second surface.

In this embodiment of this application, referring to (c) in FIG. 17, Based on the image composition process, laser engraving processing (laser engraving) or etching processing may be performed on the first surface, so that the first pattern is formed on the first surface, to remove a metal layer around the first via hole on the first surface; and laser engraving processing or etching processing is performed on the second surface, so that the second pattern is formed on the second surface, to remove a metal layer around the first via hole on the second surface. Such a design can implement isolation between the first via hole and a metal structure. Usually, laser engraving processing is also referred to as laser engraving or laser marking, and is a process of processing a surface of an element by using an optical principle.

In an implementation, the conductor accommodated in the first via hole is a signal pin, which may be used as a signal terminal. The signal terminal may be electrically connected to the PCB through welding, so that a signal can be transmitted. Metal layers on the first surface and second surface of the base structure may be fastened between the two PCBs through welding. After step S3, the signal pin may be further mounted to form an interconnection system with the base structure, to connect the two PCBs. The signal terminal may be made of a metal material with better electric conduction performance, so that an insertion loss can be reduced.

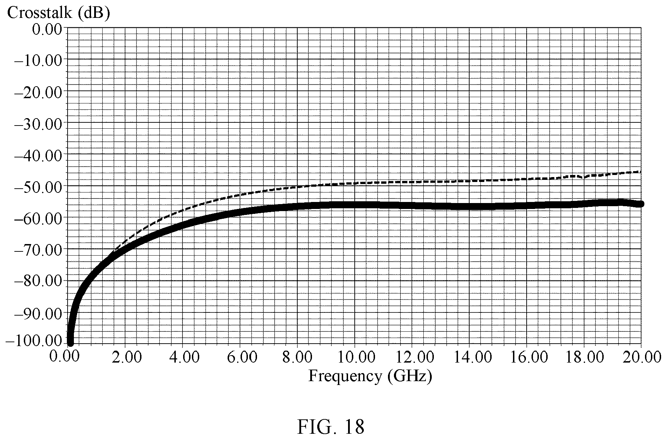

Compared with a conventional connector solution, in the connector provided in embodiments of this application, no spring plate, solder ball, or the like needs to be additionally disposed, so that a fabrication process is simplified, an assembly process is simple, and costs are lower (the costs are reduced by more than 50%). In addition, the mold for forming the base structure is simple in design and has comparatively low costs, and the mold for forming the base structure can be adjusted based on an actual signal transmission scenario of connected PCBs. It can be learned that the connector provided in this application may be applied to more scenarios. In addition, referring to FIG. 18, in the conventional connector solution, segmented isolation of a via hole is implemented, and a crosstalk status from one end to the other end of a connector is shown by a dashed line. By contrast, in the connector provided in embodiments of this application, integral isolation of a slot may be implemented, and a crosstalk status from one end to the other end of the connector is shown by a solid line. It can be learned through comparison that crosstalk of the connector provided in this application is lower than crosstalk of a connector in a conventional technology, with a gain of approximately 10 dB.

It can be learned that, in the connector provided in this application, the shielding structure may be formed by performing electroplating or chemical plating on the base structure. According to such a design, a structure with a shielding function in the connector is most simplified. Costs of the connector are reduced in two aspects: materials and a fabrication process. Then, a metal plating layer near the first via hole (signal hole) is removed through a laser engraving process or an etching process, so that the first via hole is isolated from the structure with the shielding function.

In another implementation, in step S2, the metal layer may be formed on the inner wall of the first vie hole in a process in which the metal layers are formed on all the surfaces of the base structure; and in step S3, in a process in which the first pattern is formed on the first surface, a pattern of a specific area is reserved around the first via hole, so that the pad is formed between the inner edge of the first clearance region and the first via hole. In such a design, the signal transmission channel is formed by using the pad and the metal layer on the inner wall of the first via hole, and the clearance region can isolate the signal transmission channel from another metal structure. The another metal structure may be used as the shielding structure.

It can be learned that, in the connector provided in this application, the shielding structure may be formed by performing electroplating or chemical plating on the base structure. According to such a design, a structure with a shielding function in the connector is most simplified. Costs of the connector are reduced in two aspects: materials and a fabrication process. Then, a metal plating layer near the first via hole (signal hole) is reserved through a laser engraving process or an etching process, to form the pad. In addition, the pad is isolated from the structure with the shielding function. The metal layer on the inner wall of the first via hole and the pad may be used as the signal transmission channel.

It is clear that a person skilled in the art may make various modifications and variations to this application without departing from the spirit and scope of this application. Therefore, this application is intended to cover these modifications and variations of this application provided that these modifications and variations fall within the scope of the claims of this application and equivalent technologies thereof.

## Claims

1. A connector, applied to connecting a plurality of to-be-connected objects, wherein the connector comprises:
a base structure, wherein a material of the base structure is an insulating material, at least one first via hole is disposed between a first surface and second surface of the base structure, the first via hole is configured to accommodate a conductor, the conductor is configured to connect the to-be-connected objects, and the second surface is located on a side, of the base structure, facing away from the first surface;
the first surface has a first metal layer and a first clearance region that is in one-to-one correspondence with the at least one first via hole, the first clearance region is of a ring-shaped structure, the first via hole is located in a region encircled by the corresponding first clearance region, and the first clearance region does not overlap the first metal layer;
the second surface has a second metal layer and a second clearance region that is in one-to-one correspondence with the at least one first via hole, the second clearance region is of a ring-shaped structure, the first via hole is located in a region encircled by the corresponding second clearance region, and the second clearance region does not overlap the second metal layer; and
a surface, of the base structure, other than the first surface and the second surface has a third metal layer.

2. The connector according to claim 1, wherein an inner wall of the first via hole is provided with a metal layer, wherein
the region encircled by the first clearance region is greater than a diameter of the corresponding first via hole, and a pad is formed between an inner edge of the first clearance region and the inner wall of the corresponding first via hole; and/or
the region encircled by the second clearance region is greater than the diameter of the corresponding first via hole, and a pad is formed between an inner edge of the second clearance region and the inner wall of the corresponding first via hole.

3. The connector according to claim 1, wherein the conductor is a signal terminal, and the connector further comprises the signal terminal.

4. The connector according to claim 1 or 2, wherein a projection, on the second surface, of the first clearance region corresponding to the first via hole coincides with the second clearance region corresponding to the first via hole.

5. The connector according to any one of claims 1 to 4, wherein the connector further comprises:
at least one guiding post located on the first surface and at least one guiding post located on the second surface, wherein the to-be-connected object is provided with a guiding hole configured to fit the guiding post.

6. The connector according to claim 5, wherein the connector further comprises:
at least one solder support post located on the first surface and at least one solder support post located on the second surface, wherein a thickness of the solder support post is less than a thickness of the guiding post; and when the guiding post is fitted into the guiding hole, the solder support posts support the to-be-connected objects, so that gaps are formed between the first surface and the to-be-connected object and between the second surface and the to-be-connected object, wherein the gaps are used for welding.

7. The connector according to any one of claims 1 to 6, wherein the insulating material is a plastic material.

8. The connector according to any one of claims 1 to 7, wherein the base structure is provided with at least one cavity.

9. The connector according to claim 8, wherein an inner wall of the cavity is entirely or partly provided with a metal layer.

10. A connector preparation method, comprising:
forming a base structure in a connector, wherein a material of the base structure is an insulating material, at least one first via hole is disposed between a first surface and second surface of the base structure, the first via hole is configured to accommodate a conductor, the conductor is configured to connect the plurality of to-be-connected objects, and the second surface is located on a side, of the base structure, facing away from the first surface;
forming metal layers on all surfaces of the base structure; and
based on an image composition process, forming a first pattern on the first surface and forming a second pattern on the second surface, wherein the first pattern comprises a first clearance region that is in one-to-one correspondence with the at least one first via hole, the first clearance region is of a ring-shaped structure, the first via hole is located in a region encircled by the corresponding first clearance region, the second pattern comprises a second clearance region that is in one-to-one correspondence with the at least one first via hole, the second clearance region is of a ring-shaped structure, and the second via hole is located in a region encircled by the corresponding second clearance region.

11. The method according to claim 10, wherein the insulating material is plastic, and the forming a base structure in a connector comprises:
forming the base structure through an injection molding process.

12. The method according to claim 10 or 11, wherein the forming metal layers on all surfaces of the base structure comprises:
forming the metal layers on all the surfaces of the base structure through an electroplating process or a chemical plating process.

13. The method according to any one of claims 10 to 12, wherein the based on an image composition process, forming a first pattern on the first surface and forming a second pattern on the second surface comprises:
performing laser engraving processing or etching processing on the first surface to form the first pattern on the first surface; and
performing laser engraving processing or etching processing on the second surface to form the second pattern on the second surface.

14. An interconnection system, comprising the connector according to any one of claims 1 to 9 and to-be-connected objects.

15. A communication device, comprising one or more interconnection systems, wherein at least one interconnection system comprises the connector according to any one of claims 1 to 9.
